# EUROPEAN PATENT APPLICATION

(11) **EP 2 808 360 A1**
(43) Date of publication of application: **03.12.2014**
(21) Application number: 13740493.5
(22) Date of filing: 24.01.2013
(51) Int. Cl.: C08L 31/04, B32B 27/28, B32B 27/32, C03C 27/12, C08L 23/06, H01L 31/042

(54) **COMPOSITION FOR PRODUCING SHEET FOR FORMING LAMINATE, PROCESS FOR PRODUCING SAME, AND SHEET FOR FORMING LAMINATE**

(30) Priority: 27.01.2012 JP 2012015235; 24.07.2012 JP 2012163453
(71) Applicant: Bridgestone Corporation, Tokyo 104-8340 (JP)
(72) Inventor: TARUTANI Yasunori, Yokohama-shi Kanagawa 244-8510 (JP); KAGA Norihiko, Yokohama-shi Kanagawa 244-8510 (JP); KATAOKA Hisataka, Yokohama-shi Kanagawa 244-8510 (JP); INAMIYA Takato, Yokohama-shi Kanagawa 244-8510 (JP); ARAAKE Satoshi, Yokohama-shi Kanagawa 244-8510 (JP)
(74) Representative: Oxley, Robin John George
(86) International application number: PCT/JP2013/051506
(87) International publication number: WO 2013/111835

(57) **Abstract**

To provide a composition for producing a sheet for forming a laminate, which contains an ethylene-vinyl acetate copolymer and a polyethylene resin, by which the above-described problems in the width of the temperature range in which a processable viscosity range is obtained and the like are improved and which excels in processing properties such as a film-forming property when producing a sheet, and a sheet for forming a laminate using this.

A composition for producing a sheet for forming a laminate, which contains an ethylene-vinyl acetate copolymer and polyethylene, wherein the composition has a sea-island structure in which the ethylene-vinyl acetate copolymer is a sea phase and the polyethylene is an island phase, and a sheet for forming a laminate using this.

## Description

### Technical Field

The present invention relates to a composition for producing a sheet containing an ethylene-vinyl acetate copolymer and polyethylene, which is used for forming a laminate such as a sealing film for a solar cell and an interlayer for a laminated glass, and particularly relates to a composition which is excellent in processing properties such as a film-forming property.

### Background Art

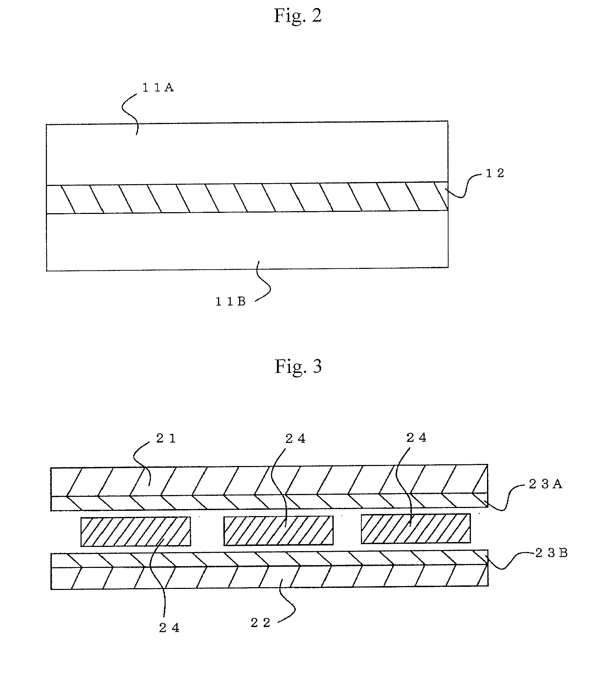

Conventionally, a sheet composed of a composition containing an ethylene-vinyl acetate copolymer (hereinafter, also referred to as EVA) as a main component (EVA sheet) is inexpensive and has high transparency, and thus, is used as an interlayer for a laminated glass, a sealing film for a solar cellphotovoltaic element, or the like. The interlayer for a laminated glass is, as shown in Figure 2, sandwiched between glass plates 11A and 11B, and exerts functions such as a penetration resistance property and shatter prevention of a damaged glass. The sealing films for a solar cell are, as shown in Figure 3, arranged between photovoltaic elementssolar cellphotovoltaic element 24 and a front side transparent protecting member 21 composed of a glass substrate or the like and between the solar cellphotovoltaic elements 24 and a backside protecting member (back cover) 22, and exert functions such as ensuring of an insulating property and ensuring of mechanical durability.

In recent years, for the purpose of improvement in a heat resistance property, a creep resistance property, a vapor permeation resistance property, and the like, a composition for a sealing film and a sealing sheet containing an ethylenic copolymer such as EVA and a polyolefin such as polyethylene (hereinafter, also referred to as PE) have been developed (Patent Documents 1, 2).

### Prior Art Documents

### Patent Document

Patent Document 1: JP (TOKKAI) 2001-332750 A
Patent Document 2: JP (TOKKAI) 2010-059277 A

### Summary of the Invention

### Problem to be Solved by the Invention

However, according to the study of the present inventors, in a composition in which EVA and polyethylene are mixed as described in Patent Document 1 or 2, processing properties when producing a sheet sometimes decrease compared to in a composition containing EVA as a main component (EVA composition).

More specifically, in the case of film-forming a resin composition into a sheet, for example, firstly, materials are mixed by a first kneading step, and then, second kneading such as roll milling is carried out as necessary, and a film is formed by calender molding or the like. In this case, the viscosity of the resin composition in the film-forming step or the like after the first kneading step greatly influences processing properties such as a film-forming property, and thus, it is necessary to adjust the viscosity of the resin composition to be in a certain range (also referred to as processable viscosity range). The viscosity of the resin composition generally changes in accordance with temperature, and thus, the adjustment of the viscosity can be carried out by regulating the temperature of the resin composition.

In the case of the EVA composition, in the vicinity of the temperature at which the processable viscosity range is obtained, the viscosity slowly changes due to a temperature change, and thus, the width of the temperature range in which the processable viscosity range is obtained (also referred to as processable temperature width) is large. On the other hand, in the resin composition in which EVA and polyethylene are mixed, in the vicinity of the temperature at which the processable viscosity range is obtained, in particular, when the mixing ratio of polyethylene is high, a viscosity change rapidly occurs due to a temperature change and the processable temperature width becomes sometimes small.

In general, it is difficult to regulate the temperature of the resin composition in the film-forming step or the like with a high degree of accuracy, and therefore, a problem in that, when the processable temperature width of the resin composition becomes small, the resin composition becomes difficult to be processed occurs.

Furthermore, in the resin composition in which EVA and polyethylene are mixed, the temperature at which the processable viscosity range is obtained tends to be increased and energy cost is increased compared to the EVA composition. Moreover, in particular, when the mixing ratio of polyethylene is high, with an existing film-forming device for processing the EVA composition, for example, a calender molding device using water as a solvent for temperature regulation, processing may not be carried out beyond the temperature regulation range.

Therefore, it is an object of the present invention to provide a composition for producing a sheet for forming a laminate, which comprises an ethylene-vinyl acetate copolymer and polyethylene, by which the above-described problems in the width of the temperature range in which a processable viscosity range is obtained and the like are improved and which is excellent in processing properties such as a film-forming property when producing a sheet.

Moreover, it is an object of the present invention to provide a process for producing the above-described composition for producing a sheet for forming a laminate.

Furthermore, it is an object of the present invention to provide a sheet for forming a laminate, using the above-described composition for producing a sheet for forming a laminate.

### Means for Solving Problem

The above-described objects are achieved by a composition for producing a sheet for forming a laminate, which comprises an ethylene-vinyl acetate copolymer and polyethylene, wherein the composition has a sea-island structure in which the ethylene-vinyl acetate copolymer is a sea phase and the polyethylene is an island phase.

Accordingly, even in a composition in which an ethylene-vinyl acetate copolymer (EVA) and polyethylene (PE) are mixed, the processable temperature width in the same range as that of the EVA composition is obtained, the temperature at which the processable viscosity range is obtained is also closer to that of the EVA composition, and processing properties can be improved. It is considered that this is because the EVA component is a sea phase (continuous phase) and the PE component is an island phase in the above-described composition, and thus, physical properties of PE become difficult to be expressed compared to the case of a co-continuous structure of EVA and PE, or the case where the EVA component as an island phase and the PE component as a sea phase are mixed.

Preferred aspects of the composition for producing a sheet for forming a laminate of the present invention are as follows.
(1) The volume ratio of the ethylene-vinyl acetate copolymer (EVA) to the polyethylene (PE), (EVA:PE), is in a range of 90:10 to 30:70. With the blending ratio in this range, the effect of improving a heat resistance property and the like by blending PE is obtained, and the composition which excels in processing properties by including the above-described sea-island structure can be obtained.
(2) The sea-island structure is obtained by kneading the ethylene-vinyl acetate copolymer (EVA) and the polyethylene (PE) under a condition where the viscosity of the PE (V_{PE} [Pa·s]), is 0.1 to 20 times with respect to the viscosity of the EVA (V_{EVA} [Pa·s]). Accordingly, the composition having the higher blending ratio of PE and the sea-island structure can be obtained.
(3) The sea-island structure is obtained by kneading the ethylene-vinyl acetate copolymer and the polyethylene under a condition of the shear rate of 10 to 1500 s⁻¹.
(4) The average diameter ((average long diameter (1) + average short diameter (d))/2) of the polyethylene island phase is 40 µm or less. Accordingly, processing properties of the resin composition can be further improved. Moreover, by thickening the island phase, the blending ratio of PE can be further increased. The average diameter ((average long diameter (1) + average short diameter (d))/2) of the PE island phase is preferably 5 to 25 µm.
(5) The average aspect ratio (average long diameter (1)/average short diameter (d)) of the polyethylene island phase is 40 or less. Accordingly, the blending ratio of PE can be further increased.
(6) The temperature at which the viscosity of the composition is 30,000 Pa·s is 70 to 100°C, and the width of the temperature range in which the viscosity of the composition is 20,000 to 50,000 Pa·s is 5.0°C or more.
(7) The polyethylene comprises one or more polyethylenes selected from low-density polyethylene and/or linear low-density polyethylene. These polyethylenes are preferable in that the melting point is relatively low and the degree of crystallization is low.
(8) The polyethylene comprises two or more polyethylenes.
(9) The polyethylene comprises one or more low-density polyethylenes and one or more linear low-density polyethylenes. By using low-density polyethylenes and linear low-density polyethylenes together, the composition which excels in tensile strength and has a relatively-low melting point can be obtained.
(10) The melt flow rate defined in JIS K7210 of the ethylene-vinyl acetate copolymer is 1.0 to 50 g/10 min.
(11) The vinyl acetate content of the ethylene-vinyl acetate copolymer is 20 to 40% by weight.

Moreover, the objects of the present invention are achieved by a process for producing the composition for producing a sheet for forming a laminate of the present invention, including a kneading step for kneading the ethylene-vinyl acetate copolymer (EVA) and the polyethylene (PE) under a condition where the viscosity of the PE (V_{PE} [Pa·s]) is 0.1 to 20 times with respect to the viscosity of the EVA (V_{EVA} [Pa·s]).

In the production process of the present invention, the kneading step is preferably a step for kneading under a condition of the shear rate of 10 to 1500 s⁻¹. Moreover, the kneading step is preferably a step for kneading under a temperature condition of 70 to 130°C.

Furthermore, the objects of the present invention are achieved by a sheet for forming a laminate, which is obtained by film-forming the composition of the present invention into a sheet. The sheet for forming a laminate of the present invention is a high-quality and low-cost sheet for forming a laminate because it is produced by using the composition of the present invention and contains PE, a heat resistance property and the like are imparted thereto, and it is obtained under the same condition as the EVA composition.

The sheet for forming a laminate of the present invention is preferably an interlayer for a laminated glass or a sealing film for a solar cell.

### Effects of the Invention

According to the present invention, for the composition for producing a sheet for forming a laminate, such as an interlayer for a laminated glass and a sealing film for a solar cell, whose heat resistance property and the like are improved, the composition which excels in processing properties, such as having the processable temperature width in the same range as the EVA composition, can be obtained by blending PE into EVA,. Therefore, the composition of the present invention can produce a sheet for forming a laminate under the same condition as the EVA composition, and the sheet for forming a laminate, which is obtained from this, can be said to be high-quality and low-cost.

### Brief Description of the Drawings

Figure 1 is a schematic cross-sectional view for illustrating a sea-island structure of a composition for producing a sheet for forming a laminate of the present invention.
Figure 2 is a schematic cross-sectional view of a general laminated glass.
Figure 3 is a schematic cross-sectional view of a general solar cell.

### Description of Embodiments

Hereinafter, a composition for producing a sheet for forming a laminate of the present invention will be described with reference to the drawings.

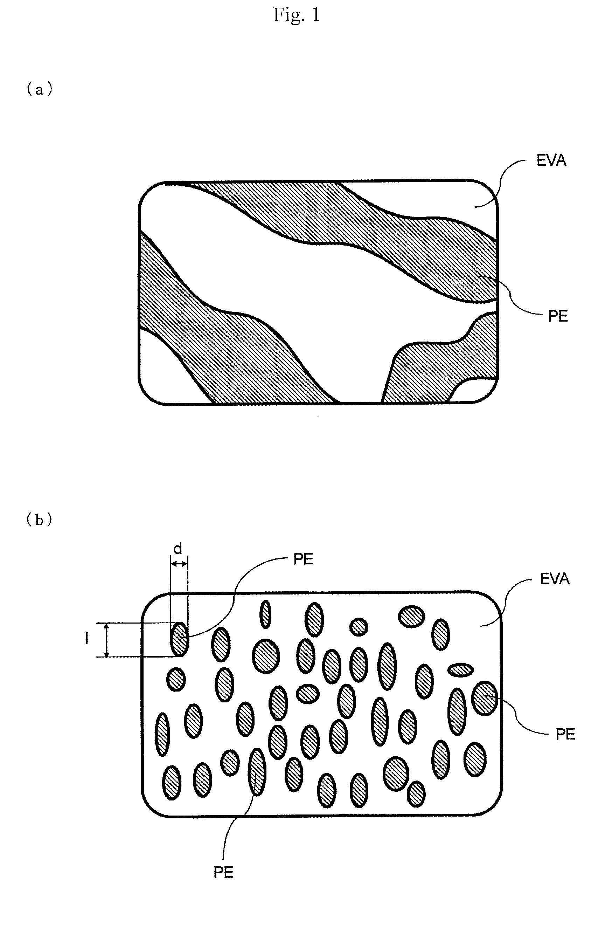

Figure 1 is a schematic cross-sectional view for illustrating a sea-island structure of the composition for producing a sheet for forming a laminate of the present invention, Figure 1(a) shows a state of a co-continuous structure of EVA and PE, and Figure 1(b) shows a state of a sea-island structure in which EVA is a sea phase (continuous phase) and PE is an island phase.

In a resin composition in which EVA and PE are mixed, although depending on the mixing ratio, an EVA component and a PE component generally have a co-continuous structure as shown in Figure 1(a). The composition for producing a sheet for forming a laminate of the present invention is characterized by containing EVA and PE, and by having a sea-island structure in which the EVA component is a sea phase and the PE component is an island phase, as shown in Figure 1(b).

In the case where a sheet for forming a laminate is produced using a resin composition, for example, as described above, firstly, a first kneading step for mixing respective materials is carried out using a biaxial kneader or the like, and then, second kneading such as roll milling is carried out as necessary, and a film is formed by calender molding, extrusion molding or the like. In this case, the viscosity of the resin composition in the film-forming step or the like after the first kneading step greatly influences processing properties such as a film-forming property, and thus, it is necessary to adjust the viscosity of the resin composition to be in a certain range (processable viscosity range). In order to obtain a good film-forming property in calender molding or the like using an EVA composition, for example, the viscosity of the resin composition in the film-forming step is preferably 5,000 to 100,000 Pa·s and further preferably 20,000 to 50,000 Pa·s.

The viscosity of the resin composition generally changes in accordance with temperature, and thus, the adjustment of the viscosity can be carried out by regulating the temperature of the resin composition. A change in the viscosity due to a temperature change varies depending on the resin composition, and thus, the width of the temperature range in which the processable viscosity range is obtained (processable temperature width) varies depending on the resin composition. Generally, it is difficult to regulate the temperature of the resin composition in the film-forming step or the like with a high degree of accuracy and the resin composition becomes difficult to be processed, and therefore, the processable temperature width of the resin composition is preferably larger, and generally, is preferably 5°C or more. Moreover, also regarding the temperature at which the processable viscosity range is obtained, energy cost is increased as the temperature increases, and furthermore, for example, in the case where a film-forming device such as a calender molding device using water as a solvent for regulating a temperature is used, processing may not be carried out beyond the temperature regulating range. Therefore, the temperature at which the processable viscosity range is obtained is preferably 95°C or less.

In the case of the EVA composition, in the vicinity of the above-described temperature at which the processable viscosity range is obtained, the viscosity slowly changes due to a temperature change, and thus, the processable temperature width of 5°C or more is obtained, and the temperature at which the processable viscosity range is obtained is 90°C or less.

On the other hand, for the resin composition in which EVA and PE are mixed, as described in the following Examples, in the case where the state of the resin composition is a general mixed composition in which the EVA component and the PE component have the co-continuous structure as shown in Figure 1(a), in the vicinity of the temperature at which the processable viscosity range is obtained, a viscosity change rapidly occurs due to a temperature change, and thus, the processable temperature width becomes small, and furthermore, the temperature at which the processable viscosity range is obtained sometimes exceeds 95°C. In contrast, in the case where, even if the blending ratio of EVA and the blending ratio of PE are the same, the state of the resin composition is the composition of the present invention having the sea-island structure in which the EVA component is a sea phase and the PE component is an island phase as shown in Figure 1(b), the processable temperature width in the same range as the EVA composition is obtained, the temperature at which the processable viscosity range is obtained can also be closer to the EVA composition, and processing properties can be improved. It is considered that this is because the EVA component is a sea phase and the PE component is an island phase, and thus, physical properties of PE become difficult to be expressed compared to the case of the co-continuous structure of EVA and PE, or the case where the EVA component as an island phase and the PE component as a sea phase are mixed.

In the composition of the present invention, although the blending ratio of EVA and PE is not particularly limited, in order to sufficiently obtain effects such as improvement in a heat resistance property, a creep resistance property, and a vapor permeation resistance property by blending PE, to sufficiently obtain the above-described sea-island structure, and to obtain a composition which excels in processing properties, the volume ratio of EVA to PE (EVA:PE) is preferably in a range of 90:10 to 30:70. Since the effects of the present invention are exerted, in particular, when the blending ratio of PE is high, EVA:PE is further preferably 60:40 to 30:70, and particularly preferably 50:50 to 30:70.

In the composition of the present invention, the above-described sea-island structure may be one obtained under any conditions. Since it is difficult for the sea-island structure to be formed in the case of the composition having the higher blending ratio of PE, a kneading condition is preferably adjusted. For example, when kneading EVA and PE, the sea-island structure is preferably obtained by kneading under a condition where the viscosity of PE (V_{PE} [Pa·s]) is 0.1 to 20 times with respect to the viscosity of EVA (V_{EVA} [Pa·s]). In the case where EVA and PE are kneaded under this condition, the composition having the higher blending ratio of PE and the sea-island structure can be obtained. In particular, in the case of the composition in which the blending ratio of PE is higher than the blending ratio of EVA, in the above-described kneading condition, the viscosity of PE (V_{PE} [Pa·s]) with respect to the viscosity of EVA (V_{EVA} [Pa·s]) is more preferably more than 1 time and 20 times or less, further preferably 2 to 15 times, and particularly preferably 4 to 13 times. Accordingly, the EVA component flows more than the PE component, and thus, even the small amount of EVA blended flows well and it becomes easy for only EVA to form a continuous phase. Accordingly, the composition having the higher blending ratio of PE and the sea-island structure can be obtained.

Moreover, under the above-described condition, the viscosity of EVA (V_{EVA}) is preferably 1000 to 50,000 Pa·s, and further preferably 2,000 to 20,000 Pa·s. On the other hand, the viscosity of PE (V_{PE}) is preferably 20,000 to 120,000 Pa·s, and further preferably 30,000 to 50,000 Pa·s. The viscosities of these resins can be measured, for example, using a capillary rheometer at the shear rate of 6.1 s⁻¹ and a temperature of the actual processing temperature. The above-described viscosity ratio can be calculated from the viscosities.

Moreover, as a condition for forming the above-described sea-island structure, the shear rate when kneading EVA and PE is preferably 10 to 1500 s⁻¹. Accordingly, the PE island phase can be formed to be denser, and the composition having the higher blending ratio of PE and the sea-island structure can be obtained. In the above-described kneading condition, the shear rate is further preferably 100 to 1000 s⁻¹, and particularly preferably 200 to 800 s⁻¹.

Since the composition of the present invention exerts effects at a stage of being used in a film-forming step in the production of a sheet for forming a laminate, the temperature at which the viscosity of the composition is 30,000 Pa·s (center processable temperature in the composition of the present invention) is preferably 70 to 100°C, and further preferably 80 to 95°C. Moreover, the width of the temperature range in which the viscosity of the composition is 20,000 to 50,000 Pa·s (processable temperature width of the composition of the present invention) is preferably 5.0°C or more.

These relationships between the viscosity and the temperature in the resin composition can be determined, for example, by measuring the viscosity while increasing the temperature at the shear rate of 6.1 s⁻¹ using a capillary rheometer.

In the composition of the present invention, the form (shape, size and the like) of the PE island phase, which constitutes the sea-island structure, is not particularly limited. Examples of the shape of the island phase include, as a cross-sectional shape, polygonal shapes such as a circular shape, an elliptical shape, and a rectangular shape, rounded polygonal shapes such as a rounded rectangular shape, and shapes obtained by combining these. Regarding the size of the island phase, for example, the cross-sectional shape is shown as a circular shape or an elliptical shape in Figure 1(b), and in the case where the average value of the average long diameter (1) and the average short diameter (d) of the island phase is defined as an average diameter, the average diameter ((average long diameter (1)+average short diameter (d))/2) of the island phase composed of PE is preferably 40 µm or less. Accordingly, processing properties of the resin composition can be further improved. Moreover, by making the island phase denser, the blending ratio of PE can be further increased. The average diameter of the island phase is further preferably 2 to 30 µm, and particularly preferably 5 to 25 µm. When the size of the island phase is too large, properties close to the co-continuous structure may occur, and when it is too small, the viscosity may be increased.

In addition, regarding the average diameter of the island phase, in the case where the cross-sectional shape of the island phase is a polygonal shape, a rounded polygonal shape or the like, the average long diameter (1) and the average short diameter (d) are calculated by defining the maximum distance in the longitudinal direction as the long diameter and the maximum distance in the width direction as the short diameter.

Moreover, when the average aspect ratio (average long diameter (1)/average short diameter (d)) of the PE island phase is too large, the co-continuous structure becomes easy to be formed due to unification of the island phase, and thus, it is preferably 40 or less. Accordingly, the blending ratio of PE can be further increased. The average aspect ratio of the island phase is further preferably 1 to 30, and particularly preferably 1 to 10.

These values can be calculated, for example, by measuring an island phase in a part which is arbitrarily sampled from a photograph obtained by magnifying the cross-section of the resin composition (by cross-section exposing using microtome) 1000 times or the like with an optical microscope or a transmission electron microscope, or a photograph obtained by elastic modulus mapping of the cross-section of the resin composition with AFM (atomic force microscope).

### [Polyethylene]

In the present invention, polyethylene (PE) is a polymer mainly comprising ethylene, as defined by JIS, and includes a homopolymer of ethylene, a copolymer of ethylene and 5 mol% or less of an α-olefin having 3 or more carbon atoms, such as butene-1, hexene-1, 4-methylpentene-1 and octene-1, and a copolymer of ethylene and 1 mol% or less of a non-olefin monomer having only carbon, oxygen, and hydrogen as a functional group (refer to JISK6922-1: 1997 Appendix). PE is generally classified according to the density, and examples include high-density polyethylene (HDPE (or PE-HD)), low-density polyethylene (LDPE (or PE-LD)), and linear low-density polyethylene (LLDPE (or PE-LLD)). PE may be of any type, but preferably comprises one or more polyethylenes selected from low-density polyethylene and/or linear low-density polyethylene, which has a relatively-low melting point and a low degree of crystallization.

LDPE is generally one having long-chain branch, which is obtained by polymerizing ethylene under high pressure of 100 to 350 MPa and in the presence of a radical generator such as an organic peroxide, and the density thereof is generally 0.910 g/cm³ or more and less than 0.930 g/cm³. LLDPE is generally one obtained by copolymerizing ethylene and α-olefin in the presence of a transition metal catalyst such as Ziegler catalyst, Phillips catalyst and metallocene catalyst, and the density thereof (in conformity with JIS K 7112, the same shall apply hereafter) is generally 0.910 to 0.940 g/cm³, and preferably 0.910 to 0.930 g/cm³. For these, commercially available one can be used as required.

Moreover, in the present invention, two or more PEs are preferably mixed. In particular, one or more LDPEs and one or more LLDPEs are preferably mixed. The composition which is excellent in tensile strength can be obtained by blending LLDPE, but on the other hand, LLDPE tends to have a higher melting point compared to LDPE. Thus, by using LDPE together, tensile strength is excellent, the melting point can be made to be relatively low, and the center processable temperature of the composition can be maintained to be low.

### [Ethylene-Vinyl Acetate Copolymer]

In the present invention, the content of vinyl acetate in the ethylene-vinyl acetate copolymer (EVA) is generally 20 to 45% by weight with respect to the weight of EVA. As the content of the vinyl acetate unit of EVA becomes lower, the obtained composition tends to become harder. When the content of vinyl acetate is less than 20% by weight, in the case where a sheet for forming a laminate obtained by using the composition of the present invention is cross-linked and hardened at high temperature, transparency of the sheet after cross-linking and hardening may not be sufficient. Moreover, when it exceeds 45% by weight, the hardness of the obtained sheet after cross-linking and hardening sometimes becomes insufficient, and furthermore, carboxylic acid, alcohol, amine and the like generate and it may become easy to generate foam in the surface boundary with other members and the like in the laminate.

In the present invention, in order to impart moderate flexibility to the sheet after cross-linking and hardening, the content of vinyl acetate in EVA is preferably 20 to 40% by weight, and further preferably 22 to 35% by weight.

Moreover, the melt flow rate (MFR) (in accordance with JIS-K7210) of EVA is preferably 1.0 g/10 min or more. MFR is further preferably 1.0 to 50.0 g/10 min, and particularly preferably 4.0 to 30.0 g/10 min. It is to be noted that MFR is measured under conditions of 190°C and a load of 21.18 N.

In the composition for a sealing film for a solar cell of the present invention, in addition to EVA, ethylene-unsaturated carboxylic acid copolymers such as ethylene-acrylic acid copolymer and ethylene-methacrylic acid copolymer, ionomers in which a part or all of carboxyl groups of the ethylene-unsaturated carboxylic acid copolymers are neutralized with the above-described metals, ethylene-unsaturated carboxylic acid ester copolymers such as ethylene-methyl acrylate copolymer, ethylene-ethyl acrylate copolymer, ethylene-methyl methacrylate copolymer, ethylene-isobutyl acrylate copolymer and ethylene-n-butyl acrylate copolymer, ethylene-unsaturated carboxylic acid ester-unsaturated carboxylic acid copolymers such as ethylene-isobutyl acrylate-methacrylic acid copolymer and ethylene-n-butyl acrylate-methacrylic acid copolymer, ionomers in which a part or all of carboxyl groups thereof are neutralized with the above-described metals, ethylene-polar monomer copolymers such as ethylene-vinyl ester copolymer like ethylene-vinyl acetate copolymer, polyvinyl acetal resins (for example, polyvinyl formal, polyvinyl butyral (PVB resin), modified PVB), and vinyl chloride resins may be secondarily used.

In addition to EVA and PE, a cross-linking agent, a cross-linking auxiliary agent, an adhesion improver, a plasticizer and the like may be added to the composition of the present invention as necessary.

### [Cross-Linking Agent]

A cross-linking agent can form a cross-linked structure of EVA, and can improve strength, an adhesion property, and durability of a sheet for forming a laminate obtained by using the composition of the present invention. As the cross-linking agent, organic peroxides or photopolymerization initiators are preferably used. Among them, organic peroxides are preferably used since a sheet for forming a laminate, whose temperature dependency of adhesion, transparency, a moisture resistance property and a penetration resistance property is improved, is obtained.

As the organic peroxides, any organic peroxide may be used as long as it is decomposed at a temperature of 100°C or more to generate radicals. The organic peroxides are generally selected in consideration of a film-forming temperature, an adjustment condition of the composition, a hardening temperature, a heat resistance property of an adherend, and storage stability. In particular, one having a half-life of 10 hours and a decomposition temperature of 70°C or more is preferred.

From the viewpoint of a processing temperature of the resin and storage stability, examples of the organic peroxides include benzoyl peroxide hardeners, tert-hexyl peroxypivalate, tert-butyl peroxypivalate, 3,5,5-trimethylhexanoyl peroxide, di-n-octanoyl peroxide, lauroyl peroxide, stearoyl peroxide, 1,1,3,3-tetramethylbutylperoxy-2-ethylhexanoate, succinic acid peroxide, 2,5-dimethyl-2,5-di(tert-butylperoxy)hexane, 2,5-dimethyl-2,5-di(2-ethylhexanoylperoxy)hexane, 1-cyclohexyl-1-methylethylperoxy-2-ethylhexanoate, tert-hexylperoxy-2-ethylhexanoate, 4-methylbenzoyl peroxide, tert-butylperoxy-2-ethylhexanoate, m-toluoyl+benzoyl peroxide, benzoyl peroxide, 1,1-bis(tert-butylperoxy)-2-methylcyclohexane, 1,1-bis(tert-hexylperoxy)-3,3,5-trimethylcyclohexane, 1,1-bis(tert-hexylperoxy)cyclohexane, 1,1-bis(tert-butylperoxy)-3,3,5-trimethylcyclohexane, 1,1-bis(tert-butylperoxy)cyclohexane, 2,2-bis(4,4-di-tert-butylperoxycyclohexyl)propane, 1,1-bis(tert-butylperoxy)cyclododecane, tert-hexylperoxyisopropyl monocarbonate, tert-butyl peroxy maleic acid, tert-butylperoxy-3,3,5-trimethylhexane, tert-butyl peroxylaurate, 2,5-dimethyl-2,5-di(methylbenzoylperoxy)hexane, tert-butylperoxyisopropyl monocarbonate, tert-butylperoxy-2-ethylhexyl monocarbonate, tert-hexyl peroxybenzoate, and 2,5-dimethyl-2,5-di(benzoylperoxy)hexane.

As the benzoyl peroxide hardeners, any benzoyl peroxide hardenere can be used as long as it is decomposed at a temperature of 70°C or more to generate radicals, one having a half-life of 10 hours and a decomposition temperature of 50°C or more is preferable, and can be appropriately selected in consideration of a preparation condition, a film-forming temperature, a hardening (bonding) temperature, a heat resistance property of an adherend, and storage stability. Examples of the usable benzoyl peroxide hardeners include benzoyl peroxide, 2,5-dimethylhexyl-2,5-bisperoxybenzoate, p-chlorobenzoyl peroxide, m-toluoyl peroxide, 2,4-dichlorobenzoyl peroxide, and t-butylperoxy benzoate. The benzoyl peroxide hardeners may be used singly or in combination of two or more thereof.

As the organic peroxides, in particular, 2,5-dimethyl-2,5di(tert-butylperoxy)hexane, 1,1-bis(tert-hexylperoxy)-3,3,5-trimethylcyclohexane, and tert-butylperoxy-2-ethylhexyl monocarbonate are preferred. Accordingly, a sheet for forming a laminate, which has an excellent insulating property, is obtained. This kind of sheet is effective in being used as a sealing film for a solar cell.

Although not particularly limited, the content of the organic peroxide is preferably 0.1 to 5 parts by weight, and more preferably 0.2 to 3 parts by weight, with respect to 100 parts by weight of the mixture of EVA and PE.

Moreover, as the photopolymerization initiators, any of known photopolymerization initiators may be used, and one having good storage stability after blending is desirable. As the photopolymerization initiators, for example, acetophenone types such as 2-hydroxy-2-methyl-1-phenylpropan-1-one, 1-hydroxycyclohexylphenylketone, and 2-methyl-1-(4-(methylthio)phenyl)-2-morpholinopropane-1, benzoin types such as benzyldimethylketal, benzophenone types such as benzophenone, 4-phenylbenzophenone, and hydroxybenzophenone, thioxanthone types such as isopropylthioxanthone, and 2-4-diethylthioxanthone, methylphenylglyoxylate and the like can be used. Preferred examples include 2-hydroxy-2-methyl-1-phenylpropan-1-one, 1-hydroxycyclohexylphenylketone, 2-methyl-1-(4-(methylthio)phenyl)-2-morpholinopropane-1, and benzophenone. These photopolymerization initiators can be used, as necessary, by being mixed with one or two or more known and common photopolymerization promoters, for example, benzoic acid types such as 4-dimethylaminobenzoic acid or tertiary amine types, at an arbitrary ratio. Moreover, only the photopolymerization initiators may be used singly or in combination of two or more thereof.

The content of the photopolymerization initiator is preferably 0.5 to 5.0 parts by weight, with respect to 100 parts by weight of the mixture of EVA and PE.

### [Cross-Linking Auxiliary Agent]

The cross-linking auxiliary agent can improve the gel fraction of EVA, and improve an adhesion property and durability of a sheet for forming a laminate obtained by using the composition of the present invention.

The content of the cross-linking auxiliary agent is generally 10 parts by weight or less, preferably 0.1 to 5 parts by weight, and further preferably 0.1 to 2.5 parts by weight with respect to 100 parts by weight of the mixture of EVA and PE. Accordingly, a sheet for forming a laminate, which has a more excellent adhesion property, is obtained.

Examples of the cross-linking auxiliary agent (compound having radical polmerizable group as functional group) include, in addition to tri-functional cross-linking auxiliary agents such as triallyl cyanurate and triallyl isocyanurate, mono- or bi-functional cross-linking auxiliary agents such as (meth)acryl esters (for example, NK esters and the like). Among them, triallyl cyanurate and triallyl isocyanurate are preferred, and triallyl isocyanurate is particularly preferred.

### [Adhesion Improver]

As the adhesion improver, silane coupling agents can be used. Accordingly, adhesion of a sheet for forming a laminate to be obtained can be further improved. Examples of the silane coupling agents include γ-chloropropyltrimethoxysilane, vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane, and N-β-(aminoethyl)-γ-aminopropyltrimethoxysilane. These silane coupling agents may be used singly or in combination of two or more thereof. Among them, particularly preferred examples include γ-methacryloxypropyltrimethoxysilane.

The content of the silane coupling agent is preferably 0.1 to 0.7 parts by weight, and particularly preferably 0.3 to 0.65 parts by weight with respect to 100 parts by weight of the mixture of EVA and PE.

### [Others]

As the plasticizer, phosphorus-containing compounds such as phosphites such as trisisodecyl phosphite and trisnonylphenylphosphite, and phosphates, polybasic acid esters such as adipic acid ether ester, trimellitate n-octyl, phthalic acid dioctyl, adipic acid dihexyl, and sebacic acid dibutyl, polyhydric alcohol esters such as 2,2,4-trimethyl-1,3-pentanediol diisobutyrate, triethylene glycol-di-2-ethylbutyrate, tetraethylene glycol diheptanoate, and triethylene glycol dipelargonate, and epoxidized fatty acid alkyl esters can be used.

Moreover, the composition in the present invention may use additives other than the above-described materials, depending on the intended use of a sheet for forming a laminate to be obtained. For example, in the case of being used as an interlayer for a laminated glass or a sealing film for a solar cell, for improvement or adjustment of various physical properties (mechanical strength, adhesion property, optical properties such as transparency, heat resistance property, light resistance property, cross-linking rate and the like), various additives such as acryloxy group-containing compounds, methacryloxy group-containing compounds, epoxy group-containing compounds, an ultraviolet absorber, a light stabilizer, and/or an antioxidant may be added as necessary.

### [Process for Producing Composition for Producing Sheet for Forming Laminate]

A process for producing the composition for producing a sheet for forming a laminate of the present invention is not particularly limited as long as it is a condition where the above-described sea-island structure is formed. Since it is difficult for the sea-island structure to be formed, in particular, in the case of the composition having the high blending ratio of PE, a kneading condition for forming the above-described sea-island structure is preferably included. That is, it is preferred to include a kneading step for kneading EVA and PE under a condition where the viscosity of PE (V_{PE} [Pa·s]) is 0.1 to 20 times with respect to the viscosity of EVA (V_{EVA} [Pa·s]), in particular, in the case of the composition in which the blending ratio of PE is higher than the blending ratio of EVA, preferably more than 1 time and 20 times or less, further preferably 2 to 15 times, and particularly preferably 4 to 13 times is preferably included, and furthermore, the kneading step is preferably a step for kneading under a condition of the shear rate of 10 to 1500 s⁻¹, further preferably 100 to 1000 s⁻¹, and particularly preferably 200 to 800 s⁻¹.

The temperature condition of the kneading step can be appropriately adjusted depending on the kinds of EVA and PE. In the case where the cross-linking agent is contained in the composition, a temperature at which the cross-linking agent does not react or hardly react is preferable. The temperature condition is preferably 70 to 130°C, and further preferably 80 to 120°C.

The kneading step may be carried out with any device. For example, EVA and PE, and the above-described respective materials as necessary are charged into a super mixer (fast fluid mixer), a twin screw kneader, a planetary gear kneader, a single screw extruder or the like, and are preferably kneaded under the above-described conditions.

The composition of the present invention is generally produced as an intermediate in a production step of a sheet for forming a laminate, and then, is used in a film-forming step (including second kneading, as necessary), but the production step of the composition of the present invention and the film-forming step thereafter do not need to be temporally and spatially continuous steps. In terms of energy cost and quality, it is preferable that the composition of the present invention be produced and continuously used in the film-forming step.

### [Sheet for Forming Laminate]

A sheet for forming a laminate of the present invention is obtained by film-forming the composition for producing a sheet for forming a laminate of the present invention into a sheet. The sheet for forming a laminate of the present invention can be produced by a process in which the composition of the present invention is subjected to second kneading such as roll milling as necessary, and then, is molded by general extrusion molding or calender molding (calendering) to obtain a sheet-like object. The heating temperature in film-forming is, in particular, in the case of blending the cross-linking agent, preferably a temperature at which the cross-linking agent does not react or hardly react. For example, 50 to 90°C is preferable, and 40 to 80°C is particularly preferable. The thickness of the sheet for forming a laminate is not particularly limited, and can be appropriately set depending on the intended use. Generally, it is in a range of 50 µm to 2 mm.

### [Intended Use]

The sheet for forming a laminate of the present invention is a high-quality and low-cost sheet for forming a laminate because it is produced by using the composition of the present invention and contains PE, a heat resistance property and the like are imparted thereto, and it is obtained under the same condition as the EVA composition. Moreover, the sheet for forming a laminate of the present invention can be used in the same manner as a sheet formed from the EVA composition, and thus, can be preferably used as an interlayer for a laminated glass or a sealing film for a solar cell.

In the case of being used as an interlayer for a laminated glass, generally, the sheet for forming a laminate (interlayer) of the present invention is interposed between two transparent substrates, and they are joined and unified to produce a laminated glass.

For the production of the laminated glass, for example, as shown in Figure 2, a process in which an interlayer 12 is sandwiched between two transparent substrates 11A and 11B, the obtained laminate is degassed, and then, is subjected to pressing force under heating, or the like is used. These steps are carried out using, for example, a vacuum bag system, a nip roll system and the like. Accordingly, the interlayer 12 is hardened, and the interlayer 12 and the transparent substrates 11A and 11B can be bonded and unified. As production conditions, for example, the above-described laminate is preliminarily pressure-bonded at a temperature of 80 to 120°C, and is heat-treated at 100 to 150°C (especially, in the vicinity of 130°C) for 10 minutes to 1 hour to cross-link EVA. Moreover, the heat treatment may be carried out under pressure. At this time, the heat treatment is preferably carried out while pressurizing the laminate at a pressure of 1.0×10³ Pa to 5.0×10⁷ Pa. Cooling after cross-linking is generally carried out at room temperature, and in particular, more rapid cooling is preferable.

As the transparent substrates, for example, in addition to glass plates such as silicate glass, an inorganic glass plate, and an uncolored transparent glass plate, a plastic film may be used. Examples of the plastic film include a polyethylene terephthalate (PET) film, a polyethylene naphthalate (PEN) film, and a polyethylene butyrate film, and a PET film is preferable. The thickness of the transparent substrate is generally about 0.05 to 20 mm.

Moreover, in the case of being used as a sealing film for a solar cell, generally, the sheet for forming a laminate (sealing film) of the present invention is interposed between a front side transparent protecting member and a backside protecting member, and they are cross-linked and unified to seal a solar cellphotovoltaic element and produce a solar cell. In order to sufficiently seal the solar cellphotovoltaic element, it is necessary that the front side transparent protecting member, a front side sealing film, the solar cellphotovoltaic element, a backside sealing film, and the backside protecting member be laminated in this order, the laminate be preliminarily pressure-bonded under reduced pressure, remaining air in the respective layers be degassed, and then, heating and pressurizing be carried out to cross-link and harden the sealing films. It is to be noted that, in the present invention, a side of the solar cellphotovoltaic element, which is irradiated with light (light-receiving surface side) is referred to as "front side", and an opposite surface side of the light-receiving surface of the solar cellphotovoltaic element is referred to as "backside".

In producing the solar cellsolar cell, for example, as shown in Figure 3, it is necessary that the front side transparent protecting member 21, a front side sealing film 23A, the solar cellphotovoltaic element 24, a backside sealing film 23B, and the backside protecting member 22 be laminated, and the sealing films 23A and 23B be cross-linked and hardened in accordance with a conventional process such as heating and pressurizing. For the heating and pressurizing, for example, it is necessary that the laminate be heated and pressure-bonded with a vacuum laminator at a temperature of 135 to 180°C, further 140 to 180°C, and particularly 155 to 180°C, a degassing time period of 0.1 to 5 minutes, a pressing pressure of 0.1 to 1.5 kg/cm², and a pressing time period of 5 to 15 minutes. In the heating and pressuring, by cross-linking EVA contained in the front side sealing film 23A and the backside sealing film 23B, the front side transparent protecting member 21, the backside protecting member 22, and the solar cellphotovoltaic element 24 can be unified through the front side sealing film 23A and the backside sealing film 23B to seal the solar cellphotovoltaic element 24.

It is to be noted that the sheet for forming a laminate (sealing film) of the present invention can be used for not only a solar cell using a single-crystalline or polycrystalline silicon crystal type solar cellphotovoltaic element as shown in Figure 2 but also a sealing film of thin-film solar batteries such as a thin-film silicon type, a thin-film amorphous silicon type solar cell, and copper indium selenide (CIS) type solar cell. In this case, examples thereof include a structure in which on a thin-film solar cell element layer formed on a surface of a front side transparent protecting member such as a glass substrate, a polyimide substrate, and a fluorine resin type transparent substrate by a chemical vapor deposition method or the like, a backside sealing film and a backside protecting member are laminated, and they are bonded and unified, a structure in which on a solar cell element formed on a surface of a backside protecting member, a front side sealing film and a front side transparent protecting member are laminated, and they are bonded and unified, and a structure in which a front side transparent protecting member, a front side sealing film, a thin-film solar cell element, a backside sealing film, and a backside protecting member are laminated in this order, and they are bonded and unified.

Generally, the front side transparent protecting member 21 used in the present invention is preferably a glass substrate such as silicate glass. The thickness of the glass substrate is generally 0.1 to 10 mm, and preferably 0.3 to 5 mm. Generally, the glass substrate may be chemically or thermally reinforced.

As the backside protecting member 22 used in the present invention, a plastic film such as polyethylene terephthalate (PET) is preferably used. Moreover, in consideration of a heat resistance property and a moisture-heat resistance property, the backside protecting member 22 may be a fluorinated polyethylene film, or in particular, a film in which a fluorinated polyethylene film/Al/a fluorinated polyethylene film are laminated in this order.

### [Examples]

Hereinafter, the present invention will be described with reference to Examples.

### (Examples 1 to 16, Comparative Examples 1 to 5)

EVA and PE having physical properties shown in Tables 1 and 2 were kneaded at each amount blended and under a kneading condition to prepare a mixed composition of EVA and PE. The viscosity of PE with respect to the viscosity of EVA (PE viscosity/EVA viscosity) in each composition was calculated by measuring the viscosity of each resin using Capillograph (manufactured by Toyo Seiki Seisaku-Sho, Ltd.) at the shear rate of 6.1 s⁻¹ and a temperature of 120°C that is a kneading temperature.

Regarding the obtained each resin composition, the viscosity was measured while increasing the temperature at the shear rate of 6.1 s⁻¹ using Capillograph (manufactured by Toyo Seiki Seisaku-Sho, Ltd.). The width of the temperature range in which the viscosity of the composition is 20,000 to 50,000 Pa·s was determined as a processable temperature width, and the temperature at which the viscosity is 30,000 Pa·s was determined as a center processable temperature.

As a judgment of acceptance, regarding the processable temperature width, the case of 5°C or more was indicated by ○, and the case of less than 5°C was indicated by ×, and regarding the center processable temperature, the case of 70°C or more and 95°C or less was indicated by ○, the case of more than 95°C and 100°C or less was indicated by Δ, and the case of more than 100°C was indicated by ×.

Furthermore, cross-section exposing of each composition was carried out using a microtome (manufactured by Leica Microsystems), elastic modulus mapping of the cross-section was carried out using AFM (atomic force microscope) (manufactured by TOYO Corporation), and the sea-island structure of EVA and PE was observed. The case where EVA is a sea phase (continuous phase) and PE is an island phase was indicated by ○, the case where both EVA and PE become continuous phases was indicated by Δ, and the case where PE becomes a continuous phase and EVA is an island phase was indicated by ×.

Moreover, regarding those in which the PE island phase was observed, binarization image processing (in terms of resolution, in calculation, island phase having long diameter of 1.2 µm or less was considered as noise and omitted) was carried out, the long diameter and the short diameter of the island phase existing in 2,500 µm² in the case of the image by AFM (atomic force microscope) or 4900 µm² in the case of the image by an optical microscope were measured, and from the average values thereof, the average diameter ((average long diameter (1)+average short diameter (d))/2) and the average aspect ratio (average long diameter (1)/average short diameter (d)) were determined.

### (Evaluation Result)

The evaluation result is shown in Tables 1 and 2.

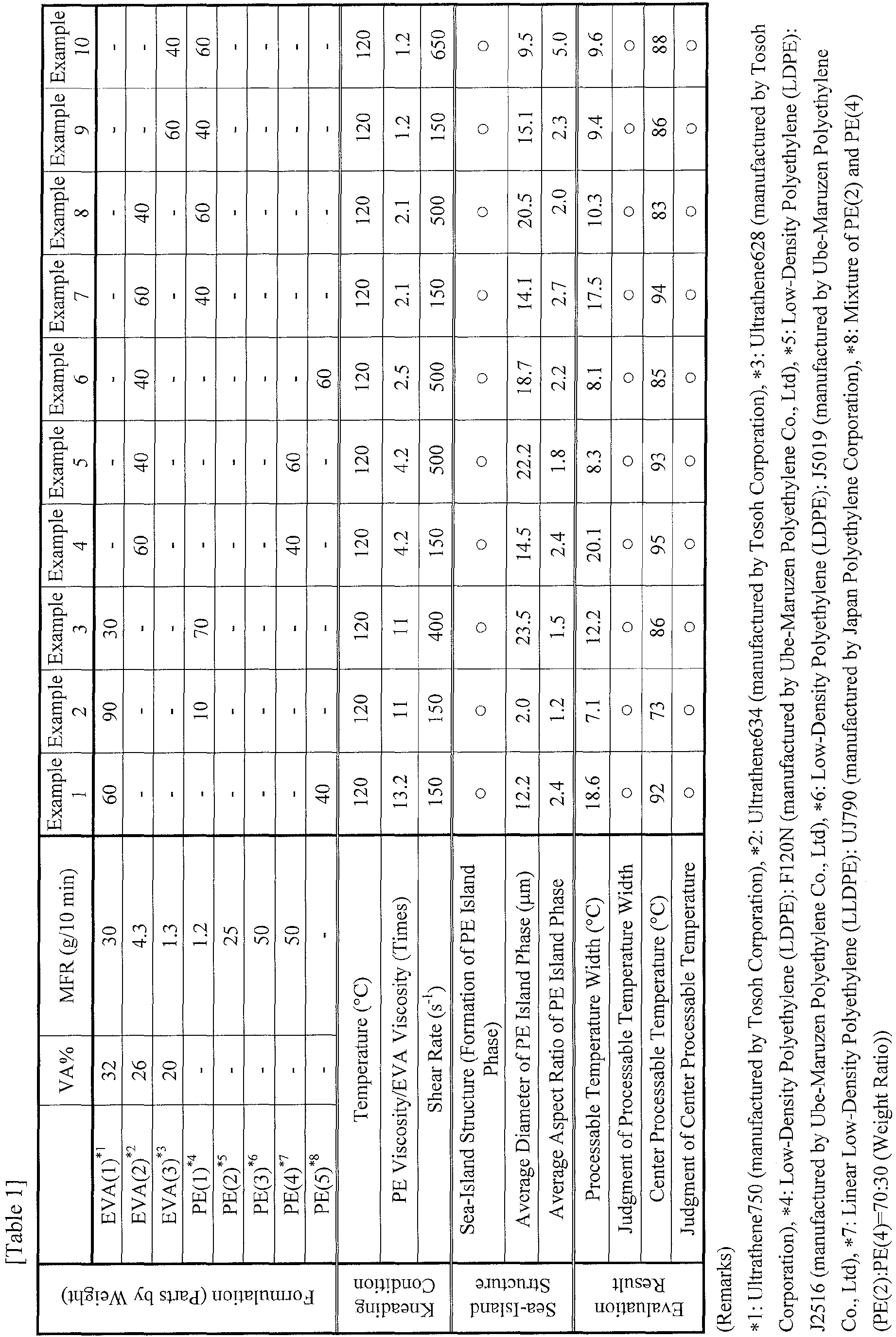

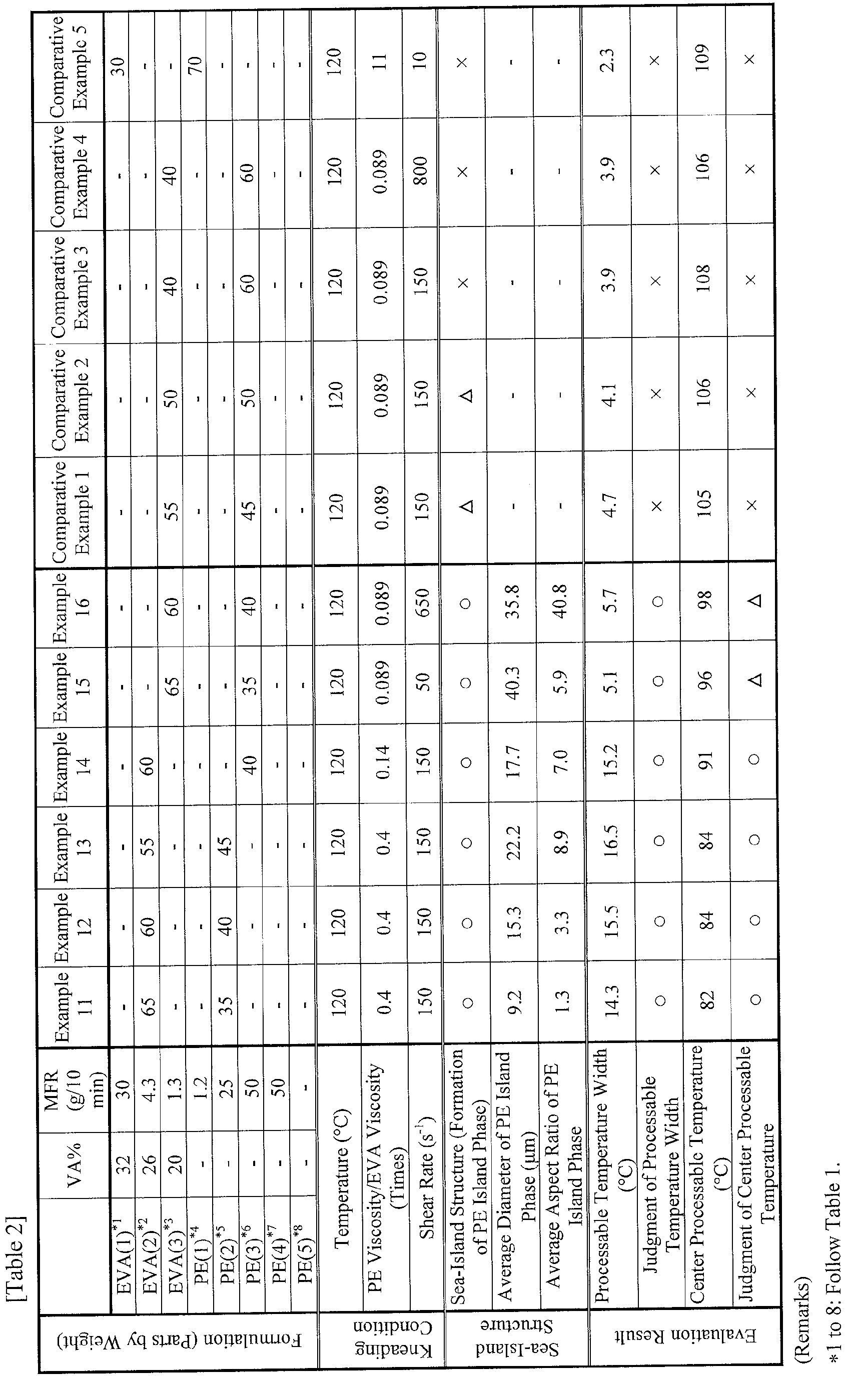

As shown in Table 1 and Table 2, in the compositions of Examples 1 to 14 having a sea-island structure in which EVA is a sea phase and PE is an island phase, the processable temperature width was 5°C or more and the center processable temperature was 95°C or less, and it was found that they are compositions which excel in processing properties such as a film-forming property in producing a sheet. The average diameter of the PE island phase of these Examples was 40 µm or less, and the average aspect ratio thereof was 40 or less. In Examples 15 and 16, the above-described sea-island structure was observed, but the average diameter of the PE island phase in Example 15 was more than 40 µm and the average aspect ratio of the PE island phase in Example 16 was more than 40. In the case of these compositions, the processable temperature width was small compared to other Examples and also the center processable temperature was more than 95 and 100°C or less, and they were compositions which are slightly difficult to be processed. It was considered that this is because, if the average diameter of the island phase is too large or the average aspect ratio is too large, properties close to the co-continuous structure are exhibited.

As the kneading condition, in the case of the composition in which the blending ratio of PE is lower than the blending ratio of EVA, as Examples 1, 2, 4, 7, 9, and 11 to 14, when the viscosity ratio of PE/EVA is 0.1 or more and the shear rate is 100 s⁻¹ or more, the above-described sea-island structure was obtained regardless of the viscosity ratio. It is to be noted that, in the case where the viscosity ratio of PE/EVA is less than 0.1 and/or the shear rate is less than 100 s⁻¹, as Examples 15 and 16, even if the above-described sea-island structure is obtained, the average diameter and the average aspect ratio of the island phase tend to become too large as described above.

In contrast, in the case of the composition in which the blending ratio of PE is higher than the blending ratio of EVA, as Examples 3, 5, 6, 8, and 10, when the viscosity ratio of PE/EVA is more than 1 time, by providing a high shear rate, the above-described sea-island structure was obtained. It was considered that this is because, EVA becomes easier to flow under the high shear rate, and even if the blending ratio of EVA is low, a continuous phase is easy to be formed.

On the other hand, in the case where the viscosity ratio of PE/EVA is low, less than 0.1, as Comparative Examples 1 to 4, the above-described sea-island structure is sometimes not obtained even at a high shear rate, and in the case where the viscosity ratio of PE/EVA is sufficiently high, 11, as Comparative Example 5, when the shear rate is low, 10 s⁻¹, the above-described sea-island structure was not obtained. In the composition which does not have a sufficient sea-island structure like this, the processable temperature width was small, less than 5°C, and also the center processable temperature was more than 100°C, and it was a composition which is difficult to be processed.

Moreover, it is found that, in contrast to Example 4 using only LLDPE, by using LDPE together as Example 1, the center processable temperature can be further decreased.

The present invention is not limited to the constitution of Embodiment and Examples described above, and can be modified in various ways within the scope of the invention.

### [Industrial Applicability]

According to the present invention, a laminated glass having high transparency and a solar cell having high power generation efficiency can be easily provided.

### [Reference Signs List]

- 11A, 11B: Transparent Substrates
- 12: Interlayer
- 21: Front side Transparent Protecting Member
- 22: Backside Protecting Member
- 23A: Front side Sealing Film
- 23B: Backside Sealing Film
- 24: Photovoltaic element

## Claims

1. A composition for producing a sheet for forming a laminate, comprising an ethylene-vinyl acetate copolymer and polyethylene,
wherein the composition has a sea-island structure in which the ethylene-vinyl acetate copolymer is a sea phase and the polyethylene is an island phase.

2. The composition according to claim 1, wherein a volume ratio (EVA:PE) of the ethylene-vinyl acetate copolymer (EVA) to the polyethylene (PE) is in a range of 90:10 to 30:70.

3. The composition according to claim 1 or 2, wherein the sea-island structure is obtained by kneading the ethylene-vinyl acetate copolymer (EVA) and the polyethylene (PE) under a condition where a viscosity of the PE (V_{PE} [Pa·s]) is 0.1 to 20 times with respect to a viscosity of the EVA (V_{EVA} [Pa·s]).

4. The composition according to any one of claims 1 to 3, wherein the sea-island structure is obtained by kneading the ethylene-vinyl acetate copolymer and the polyethylene under a condition of a shear rate of 10 to 1500 s⁻¹.

5. The composition according to any one of claims 1 to 4, wherein an average diameter ((average long diameter (1) + average short diameter (d))/2) of the polyethylene island phase is 40 µm or less.

6. The composition according to any one of claims 1 to 5, wherein an average aspect ratio (average long diameter (1)/average short diameter (d)) of the polyethylene island phase is 40 or less.

7. The composition according to any one of claims 1 to 6, wherein a temperature at which a viscosity of the composition is 30,000 Pa·s is 70 to 100°C, and a width of a temperature range in which the viscosity of the composition is 20,000 to 50,000 Pa·s is 5.0°C or more.

8. The composition according to any one of claims 1 to 7, wherein the polyethylene comprises one or more polyethylenes selected from low-density polyethylenes and/or linear low-density polyethylenes.

9. The composition according to any one of claims 1 to 8, wherein the polyethylene comprises two or more polyethylenes.

10. The composition according to claim 9, wherein the polyethylene comprises one or more low-density polyethylenes and one or more linear low-density polyethylenes.

11. The composition according to any one of claims 1 to 10, wherein a melt flow rate defined in JIS K7210 of the ethylene-vinyl acetate copolymer is 1.0 to 50.0 g/10 min.

12. The composition according to any one of claims 1 to 11, wherein a vinyl acetate content of the ethylene-vinyl acetate copolymer is 20 to 40% by weight.

13. A process for producing the composition for producing a sheet for forming a laminate according to any one of claims 1 to 12, comprising:
a kneading step for kneading the ethylene-vinyl acetate copolymer (EVA) and the polyethylene (PE) under a condition where a viscosity of the PE (V_{PE} [Pa·s]), is 0.1 to 20 times with respect to a viscosity of the EVA (V_{EVA} [Pa·s]).

14. The process according to claim 13, wherein the kneading step is a step for kneading under a condition of a shear rate of 10 to 1500 s⁻¹.

15. The process according to claim 13 or 14, wherein the kneading step is a step for kneading under a temperature condition of 70 to 130°C.

16. A sheet for forming a laminate, which is obtained by film-forming the composition according to any one of claims 1 to 12 into a sheet.

17. The sheet for forming a laminate according to claim 16, which is an interlayer for a laminated glass or a sealing film for a solar cell.
